# EUROPÄISCHE PATENTSCHRIFT

(11) **EP 3 513 425 B1**
(45) Veröffentlichungstag und Bekanntmachung des Hinweises auf die Patenterteilung: **16.11.2022**
(21) Anmeldenummer: 17771694.1
(22) Anmeldetag: 08.09.2017
(51) Int. Cl.: H01L 21/18, C01B 33/023

(54) **VERFAHREN ZUR HERSTELLUNG EINER KRISTALLINEN SILIZIUMSCHICHT UND SILIZIUMBASIERTES HALBLEITERBAUELEMENT**
METHOD FOR PRODUCING A CRYSTALLINE SILICON LAYER AND SILICON-BASED SEMICONDUCTOR COMPONENT
PROCÉDÉ DE PRODUCTION D'UNE COUCHE DE SILICIUM CRISTALLIN ET COMPOSANT SEMI-CONDUCTEUR À BASE DE SILICIUM

(30) Priorität: 13.09.2016 DE 102016117182
(43) Veröffentlichungstag der Anmeldung: 24.07.2019
(73) Patentinhaber: Technische Universität Braunschweig, 38106 Braunschweig (DE)
(72) Erfinder: PEINER, Erwin, 38114 Braunschweig (DE); WAAG, Andreas, 38102 Braunschweig (DE); PALM, Gerhard, 38173 Sickte (DE); SCHALL, Ingrid, 29640 Schneverdingen (DE); SCHALL, Heinz, 29640 Schneverdingen (DE)
(74) Vertreter: Gramm, Lins & Partner Patent- und Rechtsanwälte PartGmbB
(86) Internationale Anmeldenummer: PCT/EP2017/072642
(87) Internationale Veröffentlichungsnummer: WO 2018/050565

(56) Entgegenhaltungen:
- DE-A1-102014 003 941
- DE-A1-102014 009 462

## Beschreibung

Die Erfindung betrifft ein Verfahren zur Herstellung einer kristallinen Siliziumschicht auf der Oberfläche eines SiO₂-haltigen Substrats. Die Erfindung betrifft ferner ein siliziumbasiertes Halbleiterbauelement, das nach einem solchen Verfahren hergestellt ist.

Aus der DE 10 2014 009 462 A1 und der DE 10 2014 003 941 A1 ist bereits ein Verfahren zur Herstellung von Silizium auf Quarzsubstrat bekannt. Der Erfindung liegt die Aufgabe zugrunde, ein weiter verbessertes Verfahren sowie ein dementsprechend hergestelltes siliziumbasiertes Halbleiterbauelement anzugeben. Diese Aufgabe wird durch ein Verfahren gemäß Anspruch 1 gelöst. Dies umfasst die Herstellung einer kristallinen Siliziumschicht auf der Oberfläche eines SiO₂-haltigen Substrats mit den Schritten:
a) Bereitstellen des Substrats ohne die kristalline Siliziumschicht auf der Oberfläche,
b) Aufbringen eines oxidhaltigen Reduktionsmittels direkt oder über wenigstens eine Zwischenschicht auf der mit der kristallinen Siliziumschicht zu versehenden Oberfläche des Substrats,
c) Erzeugen der kristallinen Siliziumschicht auf dem Substrat durch Anpressen des oxidhaltigen Reduktionsmittels an das Substrat bei gleichzeitiger Erwärmung der Anordnung auf eine Prozesstemperatur, wobei das oxidhaltige Reduktionsmittel ein oxidhaltiges metallisches Reduktionsmittel ist und die Prozesstemperatur unterhalb der Schmelztemperatur des oxidhaltigen metallischen Reduktionsmittels liegt.

Die Erfindung hat den Vorteil, dass mit einfachen Mitteln beliebige SiO₂-haltige Substrate in Massenproduktion in Bauteile mit einer kristallinen Siliziumschicht konvertiert werden können. Es können beliebige SiO₂-haltige Substrate eingesetzt werden, z.B. Inseln, Teilbereiche, Inhaltsstoffe oder nur Oberflächen von einem Trägermaterial. Das Substrat oder Trägermaterial können auch flexible Folien sein. Das SiO₂-haltige Substrate oder dessen Oberfläche kann auch strukturiert sein. Es können beispielsweise Substrate in Form von Floatglas-Scheiben oder andere Quarzglassubstrate verwendet werden, dementsprechend kostengünstig konvertiert werden und nach der Konvertierung als siliziumbasiertes Halbleiterbauelement eingesetzt werden. Auf diese Weise können in großem Umfang, sowohl von der Stückzahl her als auch von den baulichen Dimensionen des Bauelementes her, solche Halbleiterbauelemente hergestellt werden, z.B. in Form von Solarzellen, TFT-Displays und anderen siliziumbasierten Halbleiterbauelementen, bis hin zu elektronischen Schaltungen. Vorteilhafterweise sind für diesen Herstellungsprozess keine Reinraumbedingungen erforderlich, insbesondere muss kein Vakuum erzeugt werden. Es muss auch kein Schutzgas verwendet werden. Das SiO₂-haltige Substrat kann insbesondere in Form einer flachen bzw. ebenen Platte bereitgestellt werden, z.B. in Form einer Glasplatte. Das SiO₂-haltige Substrat kann, abgesehen von vernachlässigbaren Verunreinigungen, aus reinem SiO₂ bestehen.

Ein weiterer Vorteil der Erfindung besteht darin, dass mittels der erläuterten, einfachen Herstellungsschritte eine Siliziumschicht mit hoher Reinheit bereitgestellt werden kann, die auch ohne nachfolgende Weiterverarbeitungsschritte bereits für Anwendungen in der Photovoltaik oder für andere Halbleiterbauteile geeignet ist. Zudem wird gleich die gewünschte kristalline Struktur des Siliziums bereitgestellt, die darüber hinaus eine feste Verbindung mit dem Substrat aufweist.

Das oxidhaltige Reduktionsmittel kann jedes oxidhaltige metallische Material sein, das geeignet ist, SiO₂ in einer Reduktionsreaktion zu kristallinem Silizium zu konvertieren. Das Reduktionsmittel kann z.B. eine oxidierte Oberfläche aufweisen, mit der es direkt oder über die wenigstens eine Zwischenschicht auf der mit der kristallinen Siliziumschicht zu versehenden Oberfläche des Substrats aufgebracht wird. Das oxidhaltige Reduktionsmittel ist ein oxidhaltiges metallisches Reduktionsmittel, z.B. ein oxidiertes metallisches Reduktionsmittel. Das oxidhaltige metallische Reduktionsmittel kann jedes Metall oder jeder metallähnliche Stoff sein, der geeignet ist, SiO₂ in einer Reduktionsreaktion zu kristallinem Silizium zu konvertieren. Geeignet sind beispielsweise Aluminium, Magnesium, Kalium, insbesondere in Form von Erdalkali. Das oxidhaltige Reduktionsmittel kann in unterschiedlichen Konsistenzen eingesetzt werden, z.B. in pastöser Form, wie z.B. Siebdruckpaste, oder in Feststoffform, z.B. als Folie. Als besonders geeignet hat sich z.B. Kondensatorfolie gezeigt. Diese weist aufgrund ihrer Oberflächenrauheit eine besonders große Oberfläche auf, so dass an der Oberfläche eine besonders gut ausgeprägte Metalloxidschicht gebildet wird.

Wird ein oxidhaltiges Reduktionsmittel in pastöser Form, wie z.B. die Siebdruckpaste, eingesetzt, kann durch diese Paste zugleich eine Dotierung, z.B. eine p-Dotierung mittels Aluminium, des Siliziums der hergestellten kristallinen Siliziumschicht erzeugt werden, zudem können elektrische Leiterbahnen auf der Oberfläche der Siliziumschicht erzeugt werden. Ein Vorteil eines solchen pastösen Reduktionsmittels besteht außerdem darin, dass es seine Position beibehält und nicht zerfließt. Mittels des oxidhaltigen Reduktionsmittels in pastöser Form kann eine strukturierte Siliziumschicht erzeugt werden, z.B. indem das pastöse Reduktionsmittel über eine Maske, die die entsprechende Strukturierung beinhaltet, auf dem Substrat aufgetragen wird und dementsprechend durch die Reduktionsreaktion nur an bestimmten Stellen, dort wo sich die Paste befindet, die Umwandlung des SiO₂ in kristallines Silizium durchgeführt wird.

Allgemein gilt, dass eine p-Dotierung des Siliziums z.B. mittels Aluminium und eine n-Dotierung z.B. mittels Magnesium als Reduktionsmittel erzeugt werden.

Das oxidhaltige Reduktionsmittel kann auch in gasförmiger Phase auf das Substrat aufgebracht werden, z.B. durch einen Aufdampfprozess. Versuche haben gezeigt, dass es beispielsweise vorteilhaft für die Erzeugung einer hochreinen kristallinen Siliziumschicht ist, wenn das oxidhaltige Reduktionsmittel in mehreren einzelnen Schritten aufgedampft wird und zwischen diesen Schritten eine Entlüftung in der Aufdampfkammer der Aufdampfanlage durchgeführt wird. Auf diese Weise wird die gerade aufgedampfte Metalloxidschicht oxidiert. Durch mehrfaches Wiederholen dieses Prozesses können dünne Metalloxidschichten erzeugt werden, die eine gute Basis für die nachfolgende Umwandlung des SiO₂ in das kristalline Silizium bildet. Bei dem Aufdampfprozess kann zum Abschluss ein längerer Aufdampfvorgang des oxidhaltigen Reduktionsmittels erfolgen, um eine dickere Abschlussschicht aus diesem Material zu erzeugen.

Eine strukturierte Ausbildung der kristallinen Siliziumschicht kann auch dadurch hergestellt werden, dass das Aufdampfen des oxidhaltigen Reduktionsmittels über eine Maske durchgeführt wird, die die entsprechende Strukturierung beinhaltet.

Beim Aufdampfprozess kann z.B. ein Dotiermaterial beigegeben werden, um die entstehende Siliziumschicht mit einer Dotierung zu versehen.

Das Aufbringen des oxidhaltigen Reduktionsmittels gemäß Schritt b) kann auch durch Aufwalzen erfolgen, z.B. dadurch, dass das oxidhaltige Reduktionsmittel mit der oxidierten Oberfläche unter Druck und ggf. unter Erwärmung auf das Substrat oder die Zwischenschicht aufgewalzt wird. Danach kann das Erzeugen der kristallinen Siliziumschicht gemäß Schritt c) erfolgen. Die Erwärmung bzw. die dadurch erreichte Prozesstemperatur kann vom Schritt b) zum Schritt c) erhöht werden.

In jedem der zuvor erläuterten Fälle kann eine Strukturierung der kristallinen Siliziumschicht auch dadurch hergestellt werden, dass das Anpressen des oxidhaltigen Reduktionsmittels an das Substrat mittels einer strukturierten Druckplatte erfolgt, d.h. einer Druckplatte, die entsprechend der gewünschten Strukturierung der Siliziumschicht entsprechende Erhebungen und Vertiefungen aufweist. An denjenigen Stellen, an denen das SiO₂ in kristallines Silizium umgewandelt werden soll, weist die Druckplatte jeweils eine Erhebung auf, sodass an diesen Stellen Druck auf das oxidhaltige Reduktionsmittel ausgeübt wird. An denjenigen Stellen, an denen die Druckplatte Vertiefungen aufweist, wird kein entsprechender Anpressdruck auf das oxidhaltige Reduktionsmittel ausgeübt, sodass darunter auch keine Umwandlung des SiO₂ in kristallines Silizium erfolgt.

Ferner kann eine Strukturierung der kristallinen Siliziumschicht auch durch lokale Lasererhitzung hergestellt werden.

Das oxidhaltige Reduktionsmittel mit oder ohne seine oxidierte Oberfläche kann auch zunächst auf einem anderen Bauelement vorbereitet werden als auf dem Substrat, z.B. auf einer Folie. Von diesem anderen Bauelement kann das so mit der oxidierten Oberfläche vorbereitete oxidhaltige Reduktionsmittel dann auf das Substrat übertragen werden, z.B. durch Anpressen, insbesondere bei gleichzeitiger Erwärmung der Anordnung.

Die auf der mit der kristallinen Siliziumschicht zu versehenden Oberfläche des Substrats aufzubringende Schicht oder die Schichten, z.B. des oxidhaltigen Reduktionsmittels und/oder die Zwischenschicht, können auch mittels galvanischer und/oder elektrochemischer Prozesse aufgebracht werden, z.B. durch Eloxieren.

Die gesamte Dauer des Verfahrens, bis die kristalline Siliziumschicht in der gewünschten Weise erzeugt ist, kann im Bereich von 30 Minuten bis fünf Stunden liegen.

Gemäß einer vorteilhaften Weiterbildung der Erfindung ist vorgesehen, dass das Anpressen mit einem anfänglich hohen Pressdruck erfolgt, der im weiteren Verlauf des Anpressvorgangs reduziert wird. Auf diese Weise kann trotz Reduzierung des Pressdrucks das erfindungsgemäße Verfahren relativ schnell durchgeführt werden. Die Reduzierung des Pressdrucks vom anfänglich hohen Wert kann beispielsweise in einer oder mehreren Stufen erfolgen und/oder mit stufenlosen Übergängen, z.B. nach einer Abklingfunktion. So kann z.B. der anfänglich hohe Pressdruck für einen kurzen Zeitraum aufrechterhalten werden, z.B. für einen Zeitraum bis zu einer halben Stunde, und danach ein verringerter Pressdruck für einen Zeitraum von z.B. ein bis drei Stunden.

Der Pressdruck, insbesondere der anfänglich hohe Pressdruck kann im Bereich von < 1,5 MPa liegen, oder < 1 MPa, somit bei relativ geringen Werten. Solche Pressdruckwerte lassen sich auch mit einfachen Geräten und Anlagen erzeugen. Je nach Art und Weise der Durchführung des Verfahrens ist der erforderliche Mindest-Pressdruck wahlweise festzulegen, z.B. bei einem Mindestwert von 20 kPa oder 50 kPa.

Gemäß der Erfindung ist vorgesehen, dass die Prozesstemperatur unterhalb der Schmelztemperatur des metallischen Reduktionsmittels liegt. Auf diese Weise kann ein Niedertemperatur-Herstellprozess für die kristalline Siliziumschicht auf der Oberfläche des SiO₂-haltigen Substrats bereitgestellt werden. Es sind insbesondere keine Erwärmungsprozesse auf extrem hohe Prozesstemperaturen erforderlich, es reichen beispielsweise Temperaturen im Bereich von 600°C, wenn Aluminium als Reduktionsmittel eingesetzt wird.

Gemäß einer vorteilhaften Weiterbildung der Erfindung ist vorgesehen, dass die Prozesstemperatur im Bereich von +/- 50°C im Bereich der Glasübergangstemperatur des Substrats liegt. Auch hierdurch kann ein günstiger, relativ niedriger Temperaturbereich für die Prozesstemperatur genutzt werden. Liegt die Glasübergangstemperatur des SiO₂-haltigen Substrats beispielsweise im Bereich von 600°C bis 630°C, so kann die Prozesstemperatur beispielsweise geringfügig geringer festgelegt werden, z.B. bei 590°C. Allgemein gilt, dass die Prozesstemperatur dann im Bereich von 550°C bis 680°C festgelegt werden kann.

Gemäß einer vorteilhaften Weiterbildung der Erfindung ist vorgesehen, dass die kristalline Siliziumschicht als Dünnschicht mit einer Schichtdicke von maximal 100 µm, insbesondere maximal 50 µm, erzeugt wird. Auf diese Weise lassen sich relativ homogene Dünnschichten der kristallinen Siliziumschicht bereitstellen, die ohne aufwendige Nachbearbeitung bereits die Grundlage für die Nutzung als siliziumbasiertes Halbleiterbauelement bilden können.

Gemäß einer vorteilhaften Weiterbildung der Erfindung ist vorgesehen, dass die kristalline Siliziumschicht mit Korngrößen im Bereich von nanokristallin bis multikristallin erzeugt wird. Auf diese Weise kann ein konstruktives Ausgangsmaterial beispielsweise für die gebäudeintegrierende Photovoltaik, TFT-Displays oder andere Halbleiterbauelemente bereitgestellt werden.

Gemäß einer vorteilhaften Weiterbildung der Erfindung ist vorgesehen, dass das Verfahren ohne Vakuum und ohne Schutzgas durchgeführt wird. Dementsprechend ist das Verfahren mit einfachen Mitteln, insbesondere mit wenig aufwendigen Geräten und Anlagen, durchführbar.

Gemäß einer vorteilhaften Weiterbildung der Erfindung ist vorgesehen, dass als Zwischenschicht zwischen dem oxidhaltigen Reduktionsmittels und der mit der kristallinen Siliziumschicht zu versehenden Oberfläche des Substrats eine Schicht aus einem weiteren oxidhaltigen Reduktionsmittel angeordnet wird und dann die Erzeugung der kristallinen Siliziumschicht durchgeführt wird. Durch die Zwischenschicht kann der Konvertierungsprozess des SiO₂ des Substrats in die kristalline Siliziumschicht weiter optimiert werden. Die Zwischenschicht kann auch ein bereits oxidiertes Material aufweisen oder daraus bestehen.

Insbesondere kann als Zwischenschicht zwischen der Oxidschicht des metallischen Reduktionsmittels und der mit der kristallinen Siliziumschicht zu versehenden Oberfläche des Substrats eine Schicht aus einem weiteren metallischen Reduktionsmittel angeordnet und dann die Erzeugung der kristallinen Siliziumschicht durchgeführt werden.

Gemäß einer vorteilhaften Weiterbildung der Erfindung ist vorgesehen, dass das weitere oxidhaltige Reduktionsmittel gleich dem erstgenannten oxidhaltigen Reduktionsmittel ist. Auf diese Weise können unerwünschte Verunreinigungen durch Fremdmaterialien vermieden werden.

Beschrieben wird ferner ein siliziumbasiertes Halbleiterbauelement, das nach einem Verfahren der zuvor erläuterten Art hergestellt ist. Das Halbleiterbauelement kann z.B. eine Solarzelle, ein TFT-Display oder ein sonstiges Halbleiterbauelement sein, einschließlich einer elektronischen Schaltung mit mehreren einzelnen Halbleiterbauelementen, die durch Strukturierung und/oder Dotierung der kristallinen Siliziumschicht hergestellt sind. Die Erfindung eignet sich somit für Halbleiterbauelemente nicht nur in kleiner Bauform, sondern auch für großflächige Halbleitersysteme, wobei die Substrate auch flexible Folien sein können, z.B. TFT-Displays oder Photovoltaik-Anwendungen jeglicher Bauform.

Das oxidhaltige Reduktionsmittel kann insbesondere in Feststoffform bereitgestellt werden, z. B. als Metallfolie oder dünnes Metallblech.

Das erfindungsgemäße Verfahren kann insbesondere ohne besondere Vorbehandlung des oxidhaltigen Reduktionsmittels erfolgen, es ist insbesondere nicht erforderlich, eine eventuell bereits oxidierte Oberfläche des oxidhaltigen Reduktionsmittels zunächst zu entfernen. Vielmehr kann eine solche vorhandene Oxidschicht vorteilhaft zur Durchführung des Verfahrens genutzt werden, was überraschend ist und nicht zu erwarten ist, da oxidierte Oberflächen beispielsweise von Aluminium oder Magnesium als ungeeignet für die Durchführung einer chemischen Reaktion gelten. Das erfindungsgemäße Verfahren kann ganz oder zumindest hauptsächlich als Festkörper-Reaktion durchgeführt werden, insbesondere ohne einen Verflüssigungsvorgang bzw. Schmelzvorgangs des oxidhaltigen Reduktionsmittels. Die Erwärmung der Anordnung auf die Prozesstemperatur kann daher auf eine Temperatur unterhalb der Schmelztemperatur des oxidhaltigen Reduktionsmittels erfolgen. Bei der Durchführung der chemischen Reaktion, bei der die kristalline Siliziumschicht auf dem Substrat durch Anpressen des oxidhaltigen Reduktionsmittels an das Substrat erfolgt, können lokal begrenzte Übergangsstellen auftreten, an denen ein Übergang in eine flüssige Phase zwischen den beteiligten Elementen erfolgen kann.

Insbesondere kann die Prozesstemperatur deutlich unterhalb der Schmelztemperatur einer oxidierten Oberfläche des oxidhaltigen Reduktionsmittels liegen, z. B. unterhalb des Schmelzpunkts einer Aluminiumoxidschicht, der bei ca. 2050 °C liegt. Im Falle der Verwendung von Aluminium als oxidhaltiges Reduktionsmittel kann die Prozesstemperatur bei maximal 630 °C liegen. Es ist damit eine Herstellung von kristallinem Silizium bei vergleichsweise geringen Temperaturen möglich.

Die Erfindung wird nachfolgend anhand eines Ausführungsbeispiels unter Verwendung von Zeichnungen näher erläutert. Die Zeichnungen zeigen in
- Figur 1: eine Anordnung zur Herstellung der kristallinen Siliziumschicht in seitlicher Schnittdarstellung und
- Figur 2: ein siliziumbasiertes Halbleiterbauelement in seitlicher Schnittdarstellung.

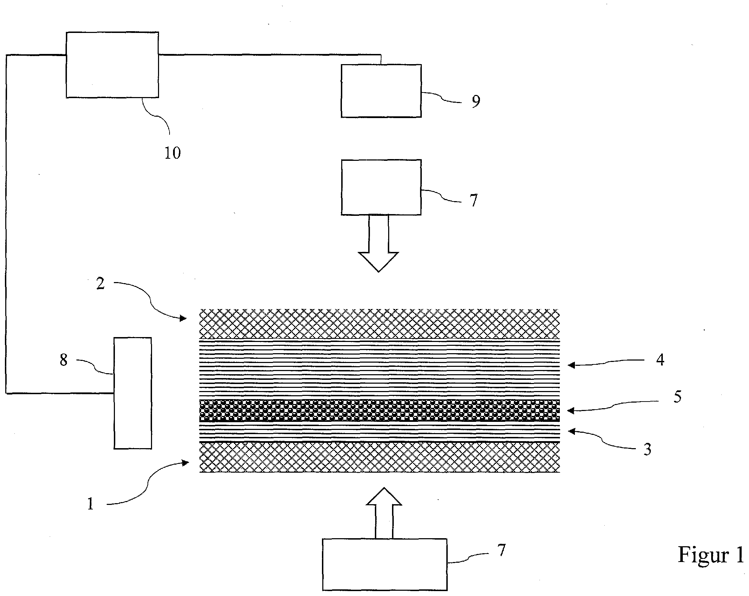

Wie erkennbar ist, ist auf einer in der Figur 1 nach oben gerichteten Oberfläche eines SiO₂-haltigen Substrats 1 entweder direkt, d.h. unmittelbar, oder über eine Zwischenschicht 3 ein oxidhaltiges Reduktionsmittel 4 mit seiner oxidierten Oberfläche 5 angeordnet. Auf der Rückseite, d.h. der von der Metalloxidschicht 5 abgewandten Seite des oxidhaltigen Reduktionsmittels 4, ist eine Rückenplatte 2 (Backing) angeordnet, die als Druckplatte für den Anpressvorgang dient. Die Rückenplatte 2 kann beispielsweise aus Metalloxidkeramik ausgebildet sein, z.B. Aluminiumoxidkeramik, wenn als oxidhaltiges Reduktionsmittel Aluminium eingesetzt wird. Auf diese Weise wird eine unerwünschte Verbindung zwischen der Rückenplatte 2 und der daran anliegenden Oberfläche des oxidhaltigen Reduktionsmittels 4 vermieden.

Die Rückenplatte 2 oder Druckplatte kann an der Seite, an der sie auf dem Reduktionsmittel anliegt, mit einem inerten Material beschichtet sein, z.B. mit Molybdän. Hierdurch kann vermieden werden, dass die Rückenplatte nach Durchführung des Anpressvorgangs zu sehr festhaftet (festklebt).

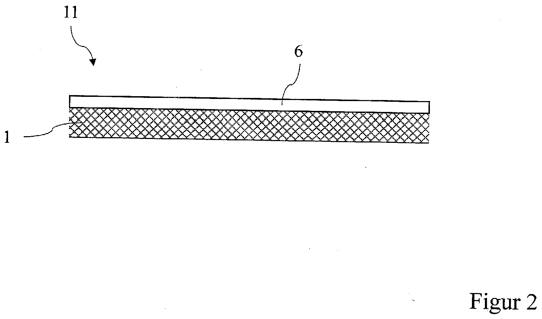

Diese Anordnung mit den Schichten 1, 2, 4, 5 und gegebenenfalls noch der Schicht 3 wird für die Durchführung des erfindungsgemäßen Verfahrens nun über Pressstempel 7 beidseitig mit einer Presskraft und dementsprechend mit einem Pressdruck beaufschlagt. Die hierfür eingesetzte Anlage weist eine Antriebseinheit 9 zur Betätigung der Pressstempel 7 auf. Ferner ist zur Durchführung der Erwärmung der dargestellten Anordnung eine Erwärmungseinrichtung 8 vorhanden. Die beschriebene Anlage kann über eine Steuereinrichtung 10, z.B. eine computergesteuerte Steuereinrichtung, automatisch gesteuert werden. Dementsprechend kann die Steuereinrichtung 10 den Antriebsmotor 9 und die Erwärmungseinrichtung 8 steuern. Für die Durchführung des erfindungsgemäßen Verfahrens wird über die Pressstempel 7 ein zunächst relativ hoher Pressdruck auf die dazwischenliegende Anordnung aufgebracht. Gleichzeitig erfolgt eine Erwärmung der Anordnung durch die Erwärmungseinrichtung 8 auf eine Prozesstemperatur. Nach einer bestimmten Einwirkzeit wird der Pressdruck verringert. Schließlich ist das Verfahren vollständig durchgeführt, d.h. es ist auf der zum oxidhaltigen Reduktionsmittel 4 gerichteten Oberfläche des Substrats 1 die gewünschte kristalline Siliziumschicht 6 erzeugt, wie die Figur 2 zeigt. Auf diese Weise wird ein siliziumbasiertes Halbleiterbauelement 11 für weitere Anwendungen bereitgestellt.

Das Anpressen des oxidhaltigen Reduktionsmittels an das Substrat kann auch mittels einer Walze erfolgen, die über das Reduktionsmittel oder die Rückenplatte 2 bewegt wird.

Die Erwärmungseinrichtung 8 kann als separate Einheit ausgebildet sein oder in andere Teile der Anlage integriert sein, z.B. in den Pressstempel 7, die Rückenplatte 8 und/oder eine Walze, wenn diese zum Anpressen genutzt wird.

## Patentansprüche

1. Verfahren zur Herstellung einer kristallinen Siliziumschicht (6) auf der Oberfläche eines SiO₂-haltigen Substrats (1) mit den Schritten:
a) Bereitstellen des Substrats (1) ohne die kristalline Siliziumschicht (6) auf der Oberfläche,
b) Aufbringen eines oxidhaltigen Reduktionsmittels (4) direkt oder über wenigstens eine Zwischenschicht (3) auf der mit der kristallinen Siliziumschicht (6) zu versehenden Oberfläche des Substrats (1),
c) Erzeugen der kristallinen Siliziumschicht (6) auf dem Substrat (1) durch Anpressen des oxidhaltigen Reduktionsmittels (4) an das Substrat (1) bei gleichzeitiger Erwärmung der Anordnung auf eine Prozesstemperatur,
**dadurch gekennzeichnet, dass** das oxidhaltige Reduktionsmittel (4) ein oxidhaltiges metallisches Reduktionsmittel (4) ist und die Prozesstemperatur unterhalb der Schmelztemperatur des oxidhaltigen metallischen Reduktionsmittels (4) liegt.

2. Verfahren nach dem vorhergehenden Anspruch, **dadurch gekennzeichnet, dass** das Anpressen mit einem anfänglich hohen Pressdruck erfolgt, der im weiteren Verlauf des Anpressvorgangs reduziert wird.

3. Verfahren nach einem der vorhergehenden Ansprüche, **dadurch gekennzeichnet, dass** das Anpressen mit einem Pressdruck von weniger als 1,5 MPa erfolgt.

4. Verfahren nach einem der vorhergehenden Ansprüche, **dadurch gekennzeichnet, dass** die Prozesstemperatur im Bereich von +/- 50°C im Bereich der Glasübergangstemperatur des Substrats (1) liegt.

5. Verfahren nach einem der vorhergehenden Ansprüche, **dadurch gekennzeichnet, dass** die kristalline Siliziumschicht (6) als Dünnschicht mit einer Schichtdicke von maximal 100 µm erzeugt wird.

6. Verfahren nach einem der vorhergehenden Ansprüche, **dadurch gekennzeichnet, dass** das Verfahren ohne Vakuum und ohne Schutzgas durchgeführt wird.

7. Verfahren nach einem der vorhergehenden Ansprüche, **dadurch gekennzeichnet, dass** als Zwischenschicht (3) zwischen dem oxidhaltigen metallischen Reduktionsmittel (4) und der mit der kristallinen Siliziumschicht (6) zu versehenden Oberfläche des Substrats (1) eine Schicht aus einem weiteren oxidhaltigen Reduktionsmittel angeordnet wird und dann die Erzeugung der kristallinen Siliziumschicht (6) durchgeführt wird.

8. Verfahren nach Anspruch 7, **dadurch gekennzeichnet, dass** das weitere oxidhaltige Reduktionsmittel gleich dem erstgenannten oxidhaltigen metallischen Reduktionsmittel (4) ist.

## Claims

1. A method of forming a crystalline silicon layer (6) on the surface of a SiO₂ - containing substrate (1), comprising the steps:
a) Providing the substrate (1) without the crystalline silicon layer (6) on the surface,
b) Application of an oxide-containing reducing agent (4) directly or via at least one intermediate layer (3) on the surface of the substrate (1) to be provided with the crystalline silicon layer (6),
c) Producing the crystalline silicon layer (6) on the substrate (1) by pressing the oxide-containing reducing agent (4) against the substrate (1) while simultaneously heating the assembly to a process temperature,
**characterized in that** the oxide-containing reducing agent (4) is an oxide-containing metallic reducing agent (4) and the process temperature is below the melting temperature of the oxide-containing metallic reducing agent (4).

2. Method according to the preceding claim, **characterized in that** the pressing is performed with an initially high pressing pressure which is reduced in the further course of the pressing process.

3. Method according to any one of the preceding claims, **characterized in that** the pressing is performed with a pressing pressure of less than 1.5 MPa.

4. Method according to any one of the preceding claims, **characterized in that** the process temperature is in the range of +/- 50°C in the range of the glass transition temperature of the substrate (1).

5. Method according to one of the preceding claims, **characterized in that** the crystalline silicon layer (6) is produced as a thin layer with a layer thickness of at most 100 µm.

6. Method according to any one of the preceding claims, **characterized in that** the process is carried out without vacuum and without inert gas.

7. Method according to one of the preceding claims, **characterized in that** a layer of a further oxide-containing reducing agent is arranged as an intermediate layer (3) between the oxide-containing metallic reducing agent (4) and the surface of the substrate (1) to be provided with the crystalline silicon layer (6), and then the generation of the crystalline silicon layer (6) is carried out.

8. Method according to claim 7, **characterized in that** the further oxide-containing reducing agent is the same as the first-mentioned oxide-containing metallic reducing agent (4).

## Revendications

1. Procédé de fabrication d'une couche de silicium cristallin (6) sur la surface d'un substrat (1) contenant du SiO₂, comprenant les étapes consistant à :
a) fournir le substrat (1) sans la couche de silicium cristallin (6) sur la surface,
b) appliquer un agent réducteur (4) contenant des oxydes sur la surface du substrat (1) à munir de la couche de silicium cristallin (6), soit directement soit par l'intermédiaire d'au moins une couche intermédiaire (3),
c) produire la couche de silicium cristallin (6) sur le substrat (1) par pressage de l'agent réducteur (4) contenant des oxydes sur le substrat (1), avec chauffage simultané de l'ensemble à une température de processus,
**caractérisé en ce que**
l'agent réducteur (4) contenant des oxydes est un agent réducteur métallique (4) contenant des oxydes, et
la température de processus est inférieure à la température de fusion de l'agent réducteur métallique (4) contenant des oxydes.

2. Procédé selon la revendication précédente,
**caractérisé en ce que** le pressage s'effectue avec une pression de pressage initialement élevée, qui est réduite pendant la poursuite de l'opération de pressage.

3. Procédé selon l'une des revendications précédentes,
**caractérisé en ce que** le pressage s'effectue avec une pression de pressage inférieure à 1,5 MPa.

4. Procédé selon l'une des revendications précédentes,
**caractérisé en ce que** la température de processus est comprise dans la plage de +/- 50°C par rapport à la température de transition vitreuse du substrat (1).

5. Procédé selon l'une des revendications précédentes,
**caractérisé en ce que** la couche de silicium cristallin (6) est réalisée sous la forme d'une couche mince d'une épaisseur de couche maximale de 100 µm.

6. Procédé selon l'une des revendications précédentes,
**caractérisé en ce que** le procédé est mis en œuvre sans vide et sans gaz de protection.

7. Procédé selon l'une des revendications précédentes,
**caractérisé en ce qu'**une couche d'un autre agent réducteur contenant des oxydes est disposée comme couche intermédiaire (3) entre l'agent réducteur métallique (4) contenant des oxydes et la surface du substrat (1) à munir de la couche de silicium cristallin (6), puis s'effectue la réalisation de la couche de silicium cristallin (6).

8. Procédé selon la revendication 7,
**caractérisé en ce que** l'autre agent réducteur contenant des oxydes est identique à l'agent réducteur métallique (4) contenant des oxydes mentionné en premier lieu.
